Europäisches Patentamt

European Patent Office

Office européen des brevets

(19)

(11) Veröffentlichungsnummer: **0 464 537 A2**

(12) # EUROPÄISCHE PATENTANMELDUNG

(21) Anmeldenummer: **91110319.0**

(22) Anmeldetag: **22.06.91**

(51) Int. Cl.5: **G11C 13/02, G11C 11/54**

(30) Priorität: **03.07.90 DE 4021077**

(43) Veröffentlichungstag der Anmeldung:
**08.01.92 Patentblatt 92/02**

(84) Benannte Vertragsstaaten:
**AT BE CH DE ES FR GB IT LI NL SE**

(71) Anmelder: **BASF Aktiengesellschaft**
**Carl-Bosch-Strasse 38**
**W-6700 Ludwigshafen(DE)**

(72) Erfinder: **Fuchs, Harald, Dr.**
**Boehlweg 32**
**W-6719 Carlsberg(DE)**
Erfinder: **Schimmel, Thomas, Dr.**
**Eppenreuther Strasse 8**
**W-8670 Hof(DE)**
Erfinder: **Keller, Harald, Dr.**
**Salinenstrasse 39**
**W-6702 Bad Duerkheim(DE)**

(54) **Verfahren zur zeitlich stabilen Markierung einzelner Atome oder Atomgruppen einer Festkörperoberfläche sowie Verwendung dieses Verfahrens zur Speicherung von Informationseinheiten im atomaren Bereich.**

(57) Die Erfindung betrifft ein Verfahren zur zeitlich stabilen Markierung einzelner Atome oder Atomgruppen einer Festkörperoberfläche durch eine lokale Entfernung individueller Atome oder Atomgruppen aus der Festkörperoberfläche sowie die Verwendung dieses Verfahrens zur Informationsspeicherung.

EP 0 464 537 A2

Die Erfindung betrifft ein Verfahren zur zeitlich stabilen Markierung einzelner Atome oder Atomgruppen einer Festkörperoberfläche durch eine lokal veränderte strukturelle und/oder elektronische Konfiguration sowie die Verwendung dieses Verfahrens zur Informationsspeicherung.

Die Speicherung von Informationen, insbesondere von Bild- und Datensignalen, erfolgt derzeit vorwiegend mit Hilfe magnetischer und optischer Aufzeichnungsträger. Die erzielbare Informationsdichte bei derartigen Aufzeichnungsträgern wird bestimmt durch die verfahrensbedingt kleinsten erzeugbaren und wieder auslesbaren Informationseinheiten. Diese sind bei den derzeit üblichen Magnetspeichern bestimmt durch die Größe der magnetischen Domänen (Weiß'sche Bezirke), in mechanischer Hinsicht durch den Kopfspalt der verwendeten Schreib/Leseköpfe sowie durch den Abstand der Schreib/Leseeinheit vom eigentlichen Informationsträger. Bei Informationsträgern, bei denen die eingespeicherte Information durch Änderung der optischen Eigenschaften erzeugt wird, liegt die Begrenzung in der verwendeten Lichtwellenlänge. Hier können somit die kleinsten Informationseinheiten nicht kleiner sein als etwa die halbe Lichtwellenlänge. Eine Steigerung der Speicherdichte bei derartigen optischen Aufzeichnungsträgern ist inzwischen auch durch die sogenannte optische Nahfeldmikroskopie erreichbar, wobei sich die optische Ausleseeinheit nur wenige Nanometer über der informationstragenden Oberfläche befindet. Erreicht werden hierbei Informationsdichten die sich derzeit bestenfalls in der Größenordnung von etwa 20 nm befinden.

Eine weitere Steigerung der Informationsdichte ist nur möglich durch die Anwendung von Nahfeldtechniken mit einer Auflösung im Subnanometerbereich. Hierzu eignen sich die sogenannten Raster-Sonden-Techniken zu denen das Raster-Tunnel-Mikroskop bzw. das Kraft-Mikroskop gehören. Diese Methoden erlauben Abbildungen von Oberflächen auf atomarer Skala. Es wurde daher schon vorgeschlagen, Informationsspeicher mit der höchstmöglichen Dichte, nämlich im Bereich der einzelnen Atome bzw. Moleküle, zu erzeugen. Die Realisierung dieser Speicher würde zu Informationsdichten führen, welche im Terabyte-Bereich pro cm$^2$ liegen.

Zur Speicherung von Informationen im Nanometerbereich auf anorganischen oder organischen Oberflächen gibt es bereits eine Reihe von Vorschlägen, so u.a. M.A. McCord et al., J.Vac.Sci.Technol. B4, 86-88 (1986), R.M. Silver et al., Appl.Phys.Lett. 51, 247-249 (1987), U. Staufer et al., J.Vac.Sci.Technol. A6, 537-539 (1988). Auch über die Abscheidung einzelner Atome wurde schon berichtet (R.S. Becker et al., Nature 325, 415-421 (1987)).

Alle bisher bekanntgewordenen Vorschläge, höchstauflösende Informationsspeicher, welche insbesondere auch über lange Zeit stabil sind, bereitzustellen, konnten jedoch nicht befriedigen. Während es bei den organischen Speichern noch nicht gelungen ist, Linienbreiten von <8 nm zu erzeugen war es bei anorganischen Systemen, welche Strukturen von bis etwa zu 3 nm ergaben, nicht möglich, diese ohne vorhergehende Veränderung der atomaren Ordnung stabil zu halten. Bei den bis jetzt bekannt gewordenen zeitlich stabilen Strukturen in Silicium (Appl.Phys.Lett. Van Loenen et al., (1989) 55, 1312-1314) wird dagegen die atomare Struktur zerstört, d.h. die atomare Ordnung geht verloren. Ein solches Verfahren eignet sich daher nur zur Erzeugung nichtlöschbarer Speicher im Nanometerbereich.

Aufgabe der vorliegenden Erfindung war es daher, ein Verfahren zur zeitlich stabilen Markierung von Atomen oder Atomgruppen bereitzustellen, mit dem insbesondere eine zeitlich stabile Speicherung von Informationen möglich ist, ohne strukturelle Veränderung der beobachteten atomaren Umgebung des veränderten Bereichs.

Es wurde nun gefunden, daß sich die Aufgabe mit einem Verfahren zur zeitlich stabilen Markierung von Atomen oder Atomgruppen in der Oberfläche eines aus einer chemischen Verbindung oder aus einer vollständig gemischten Legierung bestehenden Festkörpers lösen läßt, wenn einzelne Atome oder Atomgruppen selektiv aus der Festkörperoberfläche ohne wesentliche Veränderung der atomaren Gitterstruktur der verbleibenden Atome oder Atomgruppen entfernt werden.

Insbesondere läßt sich das erfindungsgemäße Verfahren in der Weise durchführen, daß die strukturelle und/oder elektronische Konfigurationsänderung in der Festkörperoberfläche eines halbleitenden Schichtmaterials durch kurzzeitiges Anlegen eines zeitlich und räumlich begrenzten äußeren elektrisch oder magnetischen Feldes bewirkt wird.

Bei dem erfindungsgemäßen Verfahren läßt sich die Änderung der Konfiguration besonders vorteilhaft gestalten, wenn die lokale geometrische oder elektronische Rekonfiguration durch gezielte Desorption von Atomen oder Atomgruppen einer Komponente der chemischen Verbindung oder der Legierung aus der Festkörperoberfläche an vorgegebener Stelle besteht.

Das erfindungsgemäße Verfahren der zeitlich stabilen Markierung von einzelnen Atomen oder Atomgruppen läßt sich in besonders vorteilhafter Weise für die Speicherung von Informationseinheiten heranziehen. Damit wird ein Weg aufgezeigt, die Speicherung von Informationen im atomaren Bereich vorzunehmen und somit die entsprechend hohe Informationsdichte zu erreichen. Das erfindungsgemäße Verfahren läßt sich aber nicht nur für die Informationsspeicherung verwenden, es gestattet darüber hinaus auch ein Löschen der gespeicherten Informationen. So läßt sich die gemäß dem erfindungsgemäßen Verfahren vorgenommene Speicherung von Informationseinheiten durch Rekombination der Leerstellen mit Dotierungsatomen oder Atomgruppen, welche in Festkörper enthalten sind, wieder aufheben. Dadurch wird der ursprüngliche Zustand wieder hergestellt und somit die Information gelöscht. Geeignet ist hierfür insbesondere die Zufuhr von thermischer Energie durch flächiges Aufheizen oder auch durch flächige oder punktuelle Laserbehandlung bzw. der Beschuß mit entsprechenden Dotierungsatomen der zuvor entfernten Atomsorte.

Bei der Durchführung des erfindungsgemäßen Verfahrens wird von einer Festkörperoberfläche, insbesondere einer halbleitenden Schicht ausgegangen, welche üblicherweise aus dotierten Chalkogeniden, z.B. aus $WSe_2$ besteht. In der Oberfläche einer solchen Schicht wird nun mit Hilfe der Nahfeldtechnik, z.B. mittels einer nadelförmigen Elektrode einer oberflächensensitiven Rastersonde, etwa eines Raster-Tunnelmikroskops oder eines Rasterkraftmikroskops, durch Anlegen eines kurzzeitigen elektrischen oder magnetischen Feldes die atomare Markierung vorgenommen. Da der Ort des maximalen elektrischen Feldes einer solchen Rastersonde auf der Oberfläche des halbleitenden Schichtmaterials, vorzugsweise zwischen 10 nm und 0,1 nm beträgt, lassen sich damit die atomaren bzw. elektronischen Strukturen auf der Oberfläche direkt beeinflussen. Diese lokal eingebrachte Energie bewirkt, daß eine Atomsorte der Verbindung oder Legierung desorbiert wird. Wesentlich ist dabei, daß die atomare Koordinierung der umgebenden Atome dabei nicht gestört wird und sich die Maßnahme unter normalen Umgebungsbedingungen, d.h. beispielsweise an Luft und bei Raumtemperatur, durchführen läßt.

Für die zum Einschreiben der Informationen verwendete Nahfeldtechnik lassen sich die bekannten Verfahren der Raster-Tunnel-Mikroskopie bzw. der Kraft-Mikroskopie einsetzen. Die Anordnung dieser Nahfeldtechniken ist zur Charakterisierung von Oberflächen bekannt und auch beschrieben (Y. Kuk et al., Rev.Sci.Instrum. 60(2), 165-180 (1989)).

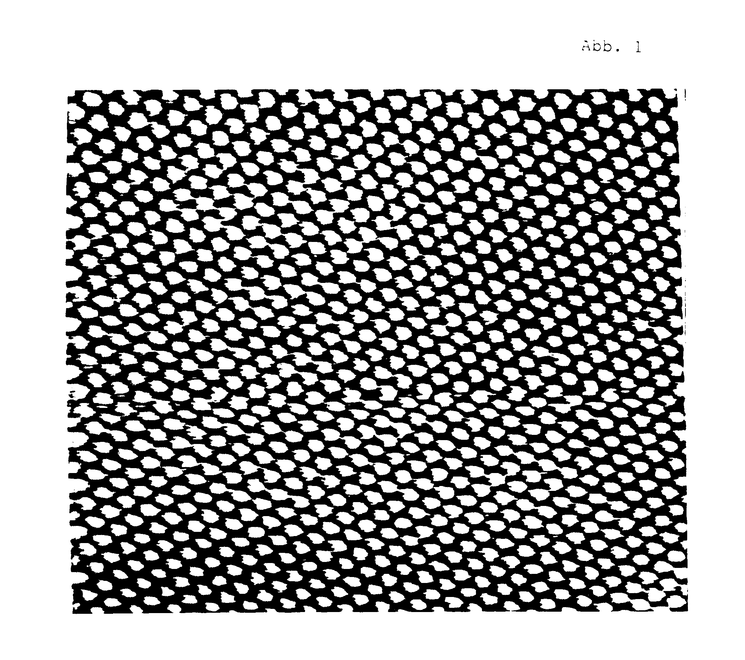

Das erfindungsgemäße Verfahren sei im folgenden beispielhaft erläutert:
Die Oberfläche einer Wolframdiselenid-Probe wurde mit einem Rastertunnelmikroskop (STM) zunächst mit atomarer Auflösung abgebildet (Abb. 1). Auf dem STM-Bild wird nur eine Spezies von Atomen, die Wolframatome, dargestellt, während die andere Spezies, die Selenatome, nicht wiedergegeben werden. Danach wurden während des Rasterscans der Tunnelspitze über die Probe mittels eines Pulsgenerators in Überlagerung zur Tunnelspannung Spannungspulse mit einer Amplitude von 0,8 bis 10 Volt zwischen Tunnelspitze und Probe für etwa 1 ms angelegt. Anschließendes Abscannen der Probe liefert atomar aufgelöste Strukturen auf deren Oberfläche, deren laterale Ausdehnung mit der Höhe der Spannungspulse zunimmt.

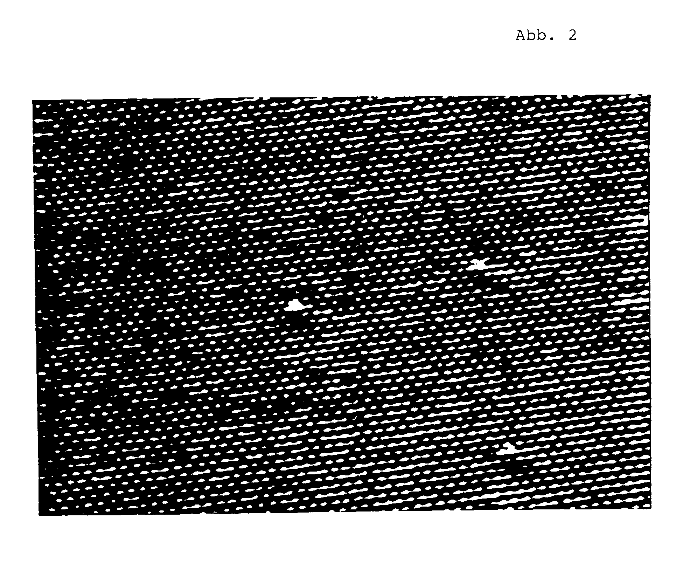

Die Desorption einzelner Atome bzw. von Atomgruppen ist in Abb. 2 verdeutlicht. Abb. 2 (Bildgröße etwa 150 x 150 Å) zeigt eine solche Oberfläche unmittelbar nach Anlegen von Spannungspulsen von ca. 1,5 Volt. Dreiergruppen von Wolframatomen wurden hier durch die Entfernung eines zwischen den drei Wolframatomen befindlichen Selenatoms gezielt verändert, wobei die relative Lage exakt den Positionen der Tunnelspitze zum Zeitpunkt des Pulses entspricht. Es ließen sich auf diese Weise Muster auf die Probe schreiben; jeder Spannungspuls markiert in definierter Position Atome, die in ihrer räumlichen bzw. elektronischen Konfiguration verändert sind.

Dabei war es problemlos möglich, mehr als 100 Strukturen mit der gleichen Spitze zu schreiben und anschließend atomar aufgelöst abzubilden. Veränderungen an der Abbildungsqualität der Probenspitze als Folge des Pulsens traten dabei normalerweise nicht auf.

Sowohl der Schreib- als auch der Ausleseprozeß können unter normalen Bedingungen, d.h. insbesondere ohne Verwendung von Inertgas, Vakuum oder tiefen Temperaturen durchgeführt werden.

Daneben konnte mit weiteren Experimenten auch gezeigt werden, daß die Anwendung von Hoch- oder Ultrahochvakuum keinen beobachtbaren Einfluß auf den Schreib- oder Lesevorgang hat.

Um die Zeitstabilität der erzeugten Markierungen zu überprüfen, wurden gezielt bestimmte Anordnungen markierter Punkte, etwa im Dreieck, im Quadrat oder als Parallelogramm, geschrieben und die resultierenden Strukturen abgebildet und in ihrer relativen Lage zueinander protokolliert; die Strukturen konnten in unveränderter Form und gleicher Anordnung nach zwei Tagen wieder aufgefunden werden. Inbesondere konnte auch gezeigt werden, daß ihre Stabilität nicht nur im Vakuum oder unter Inertgas, sondern auch an Luft gegeben ist.

Für Anwendungen als Informationsspeicher ist es wesentlich, daß der Auslesevorgang die gespeicherten Informationen nicht verändert. Dazu wurden sowohl größere als auch kleinere Strukturen (Abb. 2) auf verschiedenen Wolframdiselenid-Proben über mehrere Stunden mit dem STM abgescannt und dabei bis zu 500 mal abgebildet. In keinem Fall konnte eine Veränderung durch den Abbildungsprozess ( = Ausleseprozess bei der Anwendung als Datenträger) beobachtet werden.

Für die Anwendung als Informationsspeicher wurden somit die Funktionen Lesen, Schreiben und Löschen demonstriert und die zu ihrer Realisieriung verwendeten Verfahren angegeben; für die in Abb. 2 erzeugten Strukturen ergibt sich eine Datendichte von ca. 10 Terabyte/cm², was um einige Zehnerpotenzen die Speicherdichte von magnetischen Harddisks bzw. magnetooptischen Platten übersteigt.

**Patentansprüche**

1. Verfahren zur zeitlich stabilen Markierung einzelner Atome oder Atomgruppen in der Oberfläche eines aus einer chemischen Verbindung oder aus einer vollständig gemischten Legierung bestehenden Festkörpers, dadurch gekennzeichnet, daß einzelne Atome oder Atomgruppen selektiv aus der Festkörperoberfläche ohne wesentliche Veränderung der atomaren Gitterstruktur der verbleibenden Atome oder Atomgruppen entfernt werden.

2. Verfahren gemäß Anspruch 1, dadurch gekennzeichnet, daß die strukturelle und/oder elektronische Konfigurationsänderung durch Anlegen eines zeitlich und räumlich begrenzten äußeren elektrischen oder magnetischen Feldes bewirkt wird.

3. Verfahren gemäß Anspruch 2, dadurch gekennzeichnet, daß das zeitlich und räumlich begrenzte Feld durch die Spitze einer oberflächensensitiven Rastersonde erzeugt wird.

4. Verfahren gemäß einem der Ansprüche 1 bis 3, dadurch gekennzeichnet, daß als Festkörperoberfläche ein halbleitendes Schichtmaterial eingesetzt wird.

5. Verwendung des Verfahrens zur zeitlich stabilen Markierung einzelner Atome oder Atomgruppen gemäß einem der Ansprüche 1 bis 4 zur Speicherung von Informationseinheiten im atomaren Bereich.

Abb. 1

Abb. 2